(19) **Europäisches Patentamt**

**European Patent Office**

**Office européen des brevets**

(11) **EP 0 916 153 B1**

(12) **EUROPÄISCHE PATENTSCHRIFT**

(45) Veröffentlichungstag und Bekanntmachung des Hinweises auf die Patenterteilung:
**05.11.2003 Patentblatt 2003/45**

(21) Anmeldenummer: **98925635.9**

(22) Anmeldetag: **25.05.1998**

(51) Int Cl.⁷: $H01J\ 37/32$, $H05H\ 1/46$

(86) Internationale Anmeldenummer:
**PCT/EP98/03062**

(87) Internationale Veröffentlichungsnummer:
**WO 98/054748 (03.12.1998 Gazette 1998/48)**

(54) **VORRICHTUNG ZUR ERZEUGUNG VON PLASMA**

DEVICE FOR PRODUCING PLASMA

DISPOSITIF POUR LA PRODUCTION DE PLASMA

(84) Benannte Vertragsstaaten:
**DE ES FR GB IT LU NL**

(30) Priorität: **28.05.1997 DE 19722272**

(43) Veröffentlichungstag der Anmeldung:
**19.05.1999 Patentblatt 1999/20**

(73) Patentinhaber: **Unaxis Deutschland Holding GmbH**
**81476 München (DE)**

(72) Erfinder: **LIEHR, Michael**
**D-36325 Feldatal (DE)**

(56) Entgegenhaltungen:
**DE-A- 4 136 297          DE-C- 19 503 205**

**Beschreibung**

Die Erfindung betrifft eine Vorrichtung zur Erzeugung von Plasma in einer Vakuumkammer mit Hilfe von elektromagnetischen Wechselfeldern, wobei ein stabförmiger Leiter innerhalb eines Rohres aus isolierendem Werkstoff durch die Vakuumkammer geführt ist und der Innendurchmesser des Isolierrohres größer als der Durchmesser des Leiters ist, wobei das Isolierrohr an den beiden Enden in Wänden der Vakuumkammer gehalten und gegenüber den Wänden an seiner Außenfläche abgedichtet ist und der Leiter an beiden Enden jeweils an eine erste Quelle zur Erzeugung der elektromagnetischen Wechselfelder angeschlossen ist.

Eine bekannte Vorrichtung zur Erzeugung von Plasma (DE 195 03 205) ermöglicht es, in einem begrenzten Betriebsbereich (Prozeßbereich, Gasdruck, Mikrowellenleistung) Plasmen für Oberflächenbehandlungen und Beschichtungstechnik zu erzeugen. Die bekannte Vorrichtung besteht im wesentlichen aus einem in einer Vakuumprozeßkammer installierten zylindrischen Glasrohr und einem darin befindlichen metallisch leitenden Rohr, wobei im Innenraum des Glasrohrs Atmosphärendruck herrscht. Mikrowellenleistung wird beidseitig durch zwei Einspeisungen und zwei metallische Koaxialleitungen, bestehend aus Innenleiter und Außenleiter, durch die Wände der Vakuumprozeßkammer eingeleitet. Der fehlende Außenleiter der Koaxialleitung innerhalb der Vakuumprozeßkammer wird durch eine Plasmaentladung ersetzt, die bei hinreichenden Zündbedingungen (Gasdruck) durch die Mikrowellenleistung gezündet und aufrechterhalten wird, wobei die Mikrowellenleistung aus den beiden metallischen Koaxialleitungen und durch das Glasrohr in die Vakuumprozeßkammer austreten kann. Das Plasma umschließt das zylinderförmige Glasrohr von außen und bildet zusammen mit dem Innenleiter eine Koaxialleitung mit sehr hohem Dämpfungsbelag. Bei feststehender, beidseitig eingespeister Mikrowellenleistung kann der Gasdruck der Vakuumprozeßkammer so eingestellt werden, daß das Plasma augenscheinlich gleichmäßig entlang der Vorrichtung dort brennt, wo innerhalb der Vakuumprozeßkammer der Außenleiter der Koaxialleitung fehlt.

Wenn der Gasdruck in der Vakuumprozeßkammer bei voreingestellter Mikrowellenleistung erhöht wird, geht jedoch erfahrungsgemäß die Gleichmäßigkeit des Plasmas entlang der Vorrichtung verloren. Das Plasma in etwa halber Distanz zwischen Einspeisungspunkten der Vorrichtung wird optisch schwächer und kann ab einem gewissen Druck gänzlich erlöschen. Die Plasmalinie "reißt auf" und die beiden entstehenden Teilplasmen ziehen sich bei weiterer Druckerhöhung in Richtung der Einspeisungen zurück. Insbesondere bei langen Vorrichtungen (z. B. ab 1 m) führt dieser Effekt zu ungleichmäßigen Plasmen und daraus resultierenden ungleichmäßigen Vakuumprozessen. Die Teilplasmen zeigen hohe Leuchtkraft an den Einspeisungsenden in der Nähe der Wände und werden zur Mitte hin schwächer.

Die Beobachtung ist auf ein intrinsisches Verhalten von Koaxialleitungen zurückzuführen, wobei es offensichtlich keine Rolle spielt, ob der Außenleiter aus Metall oder elektrisch leitfähigem Plasma besteht.

Es ist bekannt, daß die Dämpfung $\alpha_c$ von transversalen elektromagnetischen Wellen pro Längeneinheit der Koaxialleitung durch die elektrische Leitfähigkeit von Innen- und Außenleiter begrenzt wird und wie folgt beschrieben werden kann:

$$\alpha_c = 13{,}6 \cdot \frac{\delta_S \cdot \sqrt{\varepsilon_R} \cdot \left\{ 1 + \left( b/a \right) \right\}}{\lambda_0 \cdot b \cdot \ln \left( b/a \right)} \qquad dB \,/\, L\ddot{a}ngeneinheit$$

Mit den Parametern

a und b   werden Außendurchmesser vom Innenleiter und Innendurchmesser vom Außenleiter einer Koaxialleitung bezeichnet,

$\delta_S$   ist die Eindringtiefe (Skin Effekt) der Mikrowellen in die leitfähigen Oberflächen,

$\lambda_0$   ist die Freiraumwellenlänge der verwendeten Mikrowellen und

$\varepsilon_R$   die relative Dielektrizitätskonstante des Dielektrikums der Koaxialleitung (= 1 für Luft).

Wie der Formel zu entnehmen ist, hängt die Dämpfung der Mikrowellen in keiner Weise von der Position entlang der Koaxialleitung ab. Da die dielektrische Füllung der Koaxialleitung aus Luft besteht und $\varepsilon_R$ über die Länge der Vorrichtung konstant ist, hängt die Höhe der Dämpfung nur von der Eindringtiefe der Mikrowellen in die leitenden Oberflächen ab. Bei konstanter Dämpfung pro Längeneinheit heißt das, daß die netto an das Plasma pro Längeneinheit abgegebene Mikrowellenleistung entlang der Vorrichtung zur Mitte hin absinkt. Da der Außenleiter aus Plasma besteht, kann diese Leitfähigkeit nicht exakt bestimmt werden. Sicherlich hängt sie von der Plasmadichte ab und diese wiederum ist in bestimmten Grenzen eine Funktion der Mikrowellenleistungsdichte im Entladungsgebiet. Sie ist vermutlich einige Größenordnungen höher als bei metallischen Oberflächen (~ 50 µm) und nicht konstant über die Länge der Vorrichtung.

Weiterhin hat sich gezeigt, daß die bekannte Vorrichtung kaum in der Lage ist, eine Plasmaentladung bei niedrigeren Drücken als $8 \times 10^{-2}$ mbar aufrechtzuerhalten. Zur Erhöhung der Flexibilität der Vorrichtung wäre es wünschenswert, Betriebsbedingungen für eine Plasmaentladung ohne Magnetfeldunterstützung auch bei niedrigeren Drükken zu gewährleisten.

Der vorliegenden Erfindung liegt die Aufgabe zugrunde, die Nachteile der bekannten Vorrichtung zu verbessern.

Diese Aufgabe wird nach Anspruch 1 dadurch gelöst, daß stabförmige Leiter jeweils im Bereich beider Wanddurchführungen in Richtung auf seine mittlere Partie zu von einem Rohrstück aus elektrisch leitendem Werkstoff beabstandet umschlossen ist, wobei die beiden Rohrstücke konzentrisch zum Isolierrohr angeordnet und jeweils an eine zweite Quelle zur Erzeugung eines elektromagnetischen Wechselfeldes angeschlossen sind.

In einer bevorzugten Ausführungsform nach Anspruch 2 ist der stabförmige Leiter von einem Rohr aus elektrisch leitendem Werkstoff beabstandet umschlossen, wobei beide Enden des Rohres jeweils an eine zweite Quelle zur Erzeugung eines elektromagnetischen Wechselfeldes angeschlossen sind, und wobei die mittlere Partie des Rohres mit einer Ausnehmung, beispielsweise einem länglichen, rhombusförmigen Längsschlitz, versehen ist.

Weitere Ausführungsmöglichkeiten, Einzelheiten und Merkmale sind in den Patentansprüchen näher beschrieben und gekennzeichnet.

Die Erfindung läßt die verschiedensten Ausführungsmöglichkeiten zu; zwei davon sind in den anhängenden Zeichnungen rein schematisch näher dargestellt, und zwar zeigen:

Fig. 1    eine Vorrichtung zur Erzeugung von Plasma im Längsschnitt und jeweils mit Rohrstücken im Bereich der beiden Enden eines stabförmigen Leiters,

Fig. 2    eine alternative Ausführungsform mit einem den stabförmigen Leiter in seiner gesamten Länge umschließenden Rohr, wobei das Rohr über einen wesentlichen Teil seiner Länge mit einer längsschlitzförmigen Ausnehmung versehen ist,

Fig. 3    das Rohr gemäß Fig. 2,

Fig. 4,5    den stabförmigen Leiter in zwei Ausführungsformen und jeweils im Querschnitt dargestellt und

Fig. 6,7    diagrammartige Darstellungen der Feldstärke des elektromagnetischen Feldes für die in den Fig. 1 und 2 gezeigten Vorrichtungen.

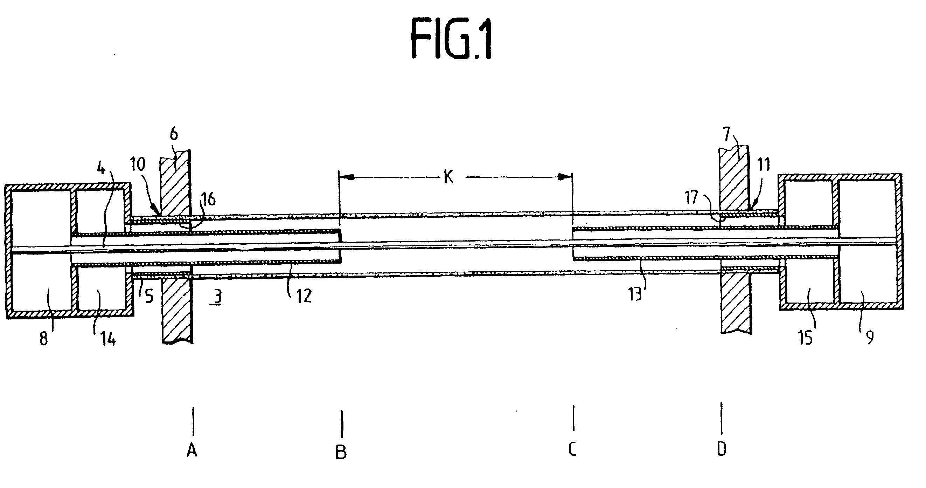

Die Vorrichtung gemäß Fig. 1 besteht im wesentlichen aus dem durch die Wandteile 6,7 der Vakuumkammer 3 hindurchgeführten Isolierrohr 5 (einem Glasrohr) mit dem zu diesem koaxial angeordneten stabförmigen Leiter 4, den jeweils an beiden Enden des Leiters 4 angeordneten ersten Quellen 8,9, den beiden den Leiter 4 umschließenden und sich ebenfalls in Leiter-Längsrichtung erstreckenden metallenen Rohrstücken 12,13, den jeweils mit den Rohrstücken 12,13 verbundenen zweiten Quellen 14,15 und den beiden Metallmanschetten 16,17, die die Bildung von Plasma im Bereich der Wanddurchführungen 10,11 verhindern.

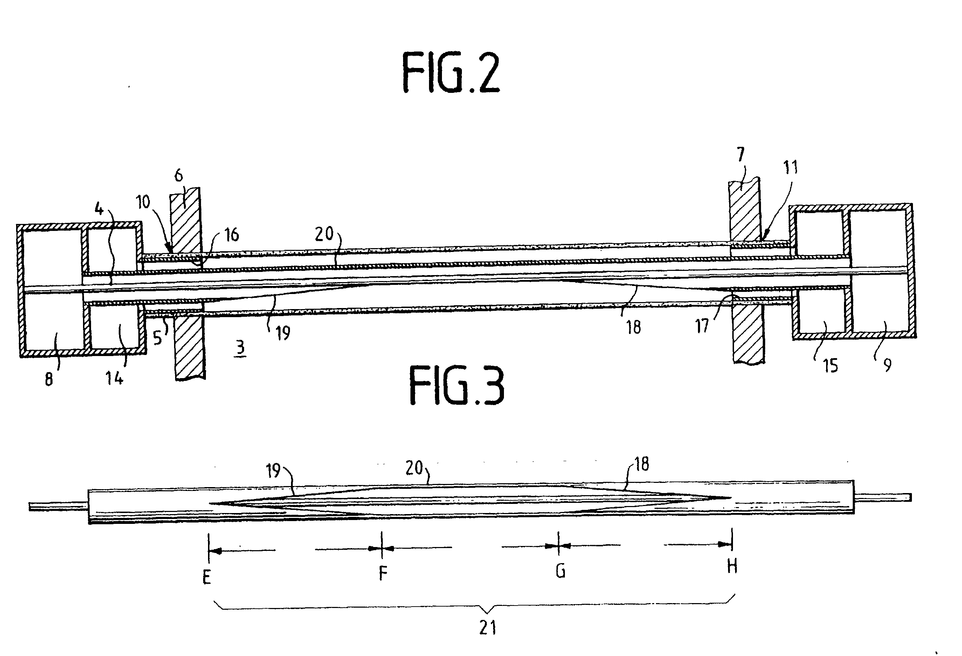

Die Ausführungsform gemäß Fig. 2 unterscheidet sich von der zuvor beschriebenen dadurch, daß der stabförmige Leiter 4 von einem einzigen Rohr 20 aus elektrisch leitendem Werkstoff beabstandet umschlossen ist, wobei beide Enden des Rohres 20 jeweils an eine zweite Quelle 14 bzw. 15 angeschlossen sind und die mittlere Partie des Rohres 20 mit einer längsschlitzförmigen Ausnehmung 21 versehen ist.

Die Vorrichtung nach Fig. 1 ist mit insgesamt vier koaxialen Mikrowelleneinspeisungen ausgestattet. Zusätzliche, metallisch leitende Rohre 12 und 13 ergeben zusammen mit dem Innenleiter 4 und den Außenleitern 16,17 insgesamt vier koaxiale, konzentrische Mikrowelleneinspeisungen, nämlich 16,12 im Bereich von A, 12,4 im Bereich von B, 13,4 im Bereich von C und 17,13 im Bereich von D. Anstatt vier konzentrischer, koaxialer Mikrowelleneinspeisungen können für längere Plasmaquellen und/oder bei höheren Gasdrücken in der Vakuumprozeßkammer auch sechs, acht oder mehr (je nach technischer Machbarkeit) Mikrowelleneinspeisungen installiert werden, wobei die Abstände (z. B. A-B oder B-C) untereinander variiert werden können, so daß eine gleichmäßige Plasmaverteilung erreicht wird. Für je zwei konzentrische Koaxialleitungen werden aber nur drei metallisch leitende Rohre gebraucht. Der Außenleiter einer inneren Koaxialleitung ist gleichzeitig der Innenleiter einer äußeren, die innere Koaxialleitung umschließende Koaxialleitung.

Bei der Vorrichtung nach Fig. 1 sind die Übergänge von der metallischen Koaxialleitung zur "Plasma-leitung" abrupt, d. h. die Stirnflächenebenen der metallischen Außenleiter (z. B. 16) stehen senkrecht zur Mittelachse. Um der starken Dampfung (entspricht Leistungsabgabe an das Plasma) der Mikrowellenleistung an den Einspeisungspunkten entgegenzuwirken, kann der Außenleiter 20 (Fig. 2) so modifiziert werden, daß er stetig zunehmend aufgetrennt wird, wie in den Bereichen E-F und G-H angedeutet. Die metallische Koaxialleitung wird zur Mitte zunehmend durch eine Plasmaleitung ersetzt. Dies hat den Nachteil, daß das Plasma nicht radialsymmetrisch um das Glasrohr 5 brennt, was aber für die meisten Applikationen ohne Bedeutung ist. Der Übergang von einem metallischen Außenleiter zu einem Plasmaleiter kann auch anderer Gestalt sein, z. B. durch koaxiale Schlitze mit zunehmender Breite. Wesentlich ist nur, daß der Übergang nicht abrupt, sondern stetig zunehmend gestaltet ist, und daß keine Wellenreflektionen auftreten.

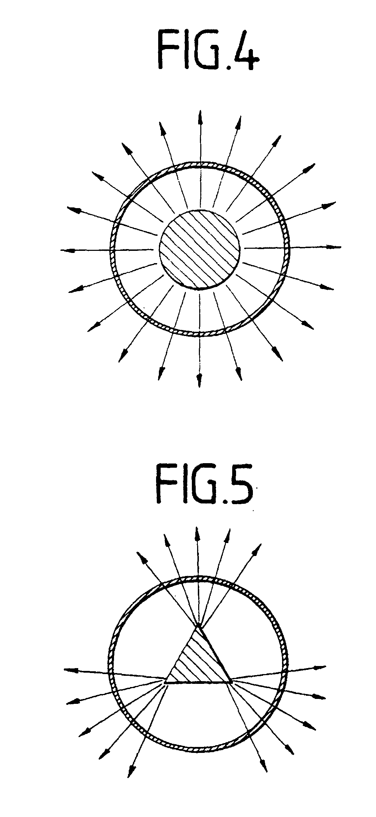

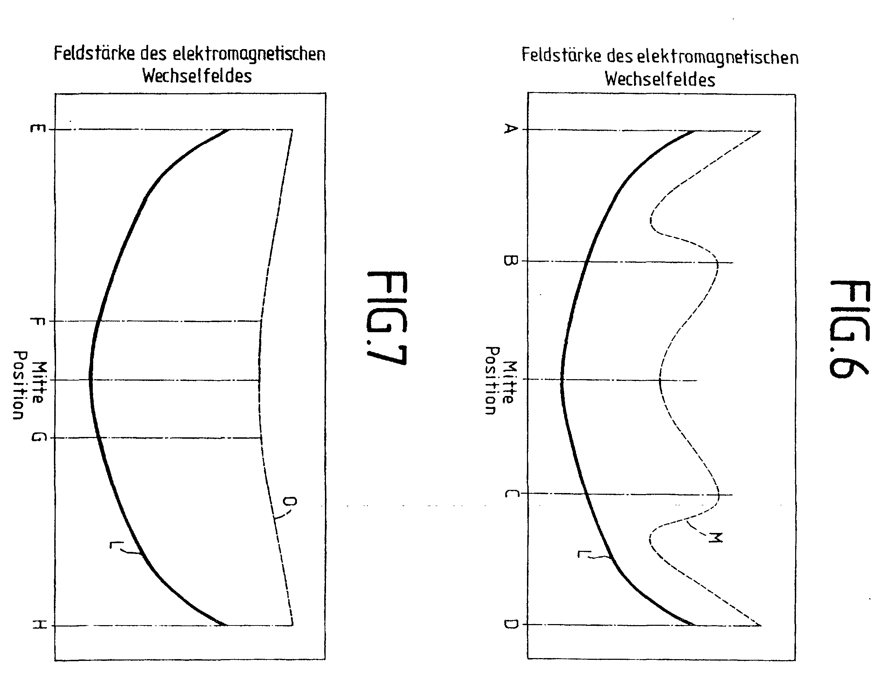

Zur Verbesserung der Plasmazündbedingungen bei hohen und auch niedrigen Gasdrücken im Entladungsvolumen ist es vorteilhaft, die Feldstärke des elektrischen Anteils des elektromagnetischen Wechselfeldes bei vorgegebener Mikrowellenleistung zu erhöhen. Dies ist auch der Vorteil von Plasmaquellen mit resonanten Strukturen (Resonatoren) gegenüber Wanderfeldstrukturen. Die bekannte Vorrichtung (DE 195 03 205) ist eine Wanderfeldstruktur und wird mit rein transversal elektromagnetischen (TEM) Wellen betrieben. Trotzdem kann auch in diesem Fall eine Feldverstärkung erreicht werden, indem der Querschnitt des metallischen Innenleiters 4 von der zylindrischen Form (Fig. 4) zu einer kantigen Form (Fig. 5) geändert wird. Die strenge Radialsymmetrie des elektrischen Anteils des elektromagnetischen Wechselfeldes im Falle des zylindrischen Innenleiters wird gebrochen und es findet eine Konzentration der elektrischen Feldlinien (mit gestrichelten Pfeilen in den Fig. 4 und 5 angedeutet) auf die Kanten statt.

Die Ausführungsform gemäß Fig. 1 bewirkt eine gleichmäßigere Verteilung der Feldstärke des elektrischen Anteils des elektromagnetischen Wechselfeldes der Mikrowellen über die gesamte Länge der Vorrichtung, wie in Fig. 6 angedeutet ist. Bei nur zwei Einspeisungspunkten A,D ergibt sich eine Verteilung gemäß der Kurve L, bei vier Einspeisungspunkten ist eine Verteilung gemäß Kurve M zu erwarten. Die abgebildeten Kurven stehen in keinem absoluten Zusammenhang, lediglich die Verläufe sind relevant. Darüber hinaus bietet die Verbesserung die Möglichkeit, die Mikrowellenleistung von einer größeren Anzahl als zwei Mikrowellengeneratoren in eine einzige Vorrichtung einzuspeisen. Dies ist beispielsweise sehr wichtig für plasmachemische Prozesse, die bei Prozeßdrucken von 50 mbar und höher (z. B. Diamantabscheidung) ablaufen.

Die Ausführungsform gemäß Fig. 2 bewirkt ebenfalls eine gleichmäßigere Verteilung der Feldstärke des elektrischen Anteils des elektromagnetischen Wechselfeldes der Mikrowellen über die gesamte Länge der Vorrichtung, wie in Fig. 7 angedeutet ist. Bei dem stetig zunehmenden Übergang von einer metallischen Koaxialleitung in eine Plasmaleitung zwischen den Punkten E-F und G-H ergibt sich eine Verteilung gemäß Kurve O. Kurve O stellt bereits nahezu die anzustrebende Idealverteilung für lineare Plasmaquellen dar. Diese Verbesserung arbeitet aber wie die ursprüngliche Vorrichtung mit nur zwei Einspeisungspunkten.

Sollen hohe Leistungsdichten an Mikrowellen entlang der Vorrichtung herrschen, so sind die Merkmale der Ausführungsformen nach den Fig. 1 und 2 zu kombinieren. Bei entsprechenden Abmessungen der Vorrichtung können auf diese Weise absolut homogene Plasmadichten über längere Strecken (z. B. 3 m) erreicht werden.

Die in Fig. 3 angedeutete Ausbildung des Rohres 20 mit der länglichen, rhombusförmigen Ausnehmung 21 bewirkt eine Erhöhung des elektrischen Anteils des elektromagnetischen Wechselfeldes in der Nähe der Kanten (verglichen mit einem zylindrischen, metallischen Innenleiter bei unveränderter Mikrowellenleistung) und damit eine Verbesserung der Plasmazünd- und Brennbedingungen bei niedrigem und auch hohem Gasdruck in der Entladungszone.

**Bezugszeichenliste**

3   Vakuumkammer
4   stabförmiger Leiter
5   Isolierrohr
6   Vakuumkammerwand
7   Vakuumkammerwand
8   erste Quelle
9   erste Quelle
10   Wanddurchführung
11   Wanddurchführung
12   Rohrstück
13   Rohrstück
14   zweite Quelle
15   zweite Quelle
16   Rohrstück, Metallmanschette
17   Rohrstück, Metallmanschette
18   keilförmiger Ausnehmungsabschnitt
19   keilförmiger Ausnehmungsabschnitt
20   Rohr

21    Ausnehmung

**Patentansprüche**

1.  Vorrichtung zur Erzeugung von Plasma in einer Vakuumkammer (3) mit Hilfe von elektromagnetischen Wechselfeldern, wobei ein stabförmiger Leiter (4) innerhalb eines Rohres (5) aus isolierendem Werkstoff durch die Vakuumkammer (3) geführt ist und der Innendurchmesser des Isolierrohres (5) größer als der Durchmesser des Leiters (4) ist, wobei das Isolierrohr (5) an beiden Enden in Wänden (6,7) der Vakuumkammer (3) gehalten und gegenüber den Wänden (6,7) an seiner Außenfläche abgedichtet ist und der Leiter (4) an beiden Enden jeweils an einer erste Quelle (8 bzw. 9) zur Erzeugung der elektromagnetischen Wechselfelder angeschlossen ist, **dadurch gekennzeichnet, daß** der stabförmige Leiter (4) jeweils im Bereich beider Wanddurchführungen (10,11) in Richtung auf seine mittlere Partie (k) zu ein Stück weit von einem Rohrstück (12,13) aus elektrisch leitendem Werkstoff beabstandet umschlossen ist, wobei die beiden Rohrstücke (12,13) konzentrisch zum Isolierrohr (5) angeordnet und jeweils die kreisringzylinderförmigen, vom Isolierrohr (5) und dem jeweiligen Rohrstück (12,13) gebildeten Zwischenräume an eine zweite Quelle (14 bzw. 15) zur Erzeugung eines elektromagnetischen Wechselfeldes angeschlossen sind.

2.  Vorrichtung zur Erzeugung von Plasma in einer Vakuumkammer (3) mit Hilfe von elektromagnetischen Wechselfeldern, wobei ein stabförmiger Leiter (4) innerhalb eines Rohres (5) aus isolierendem Werkstoff durch die Vakuumkammer (3) geführt ist und der Innendurchmesser des Isolierrohres (5) größer als der Durchmesser des Leiters (4) ist, wobei das Isolierrohr (5) an beiden Enden in Wänden (6,7) der Vakuumkammer (3) gehalten und gegenüber den Wänden (6,7) an seiner Außenfläche abgedichtet ist und der Leiter (4) an beiden Enden jeweils an einer erste Quelle (8 bzw. 9) zur Erzeugung der elektromagnetischen Wechselfelder angeschlossen ist, **dadurch gekennzeichnet, daß** der stabförmige Leiter (4) von einem Rohr (209 aus elektrisch leitendem Werkstoff beabstandet umschlossen ist und beide Enden des Rohrs (20) jeweils an eine zweite Quelle (14 bzw. 15) zur Erzeugung eines elektromagnetischen Wechselfeldes angeschlossen sind, wobei die mittlere Partie des Rohres (20) mit einer Ausnehmung (21), beispielsweise einem länglichen, rhombusförmigen Längsschlitz, versehen ist.

**Claims**

1.  Device for the production of plasma in a vacuum chamber (3) with the aid of electromagnetic alternating fields, wherein a rod-shaped conductor (4), within a tube (5) made of insulating material, is led through the vacuum chamber (3), and the internal diameter of the insulating tube (5) is larger than the diameter of the conductor (4), wherein the insulating tube (5) is held at both ends in walls (6, 7) of the vacuum chamber (3) and is sealed off relative to the walls (6, 7) on its outer surface, and the conductor (4) is connected at both ends respectively to a first source (8 or 9) to produce the electromagnetic alternating fields,
**characterised in that**
in the area of both wall bushings (10, 11) respectively, the rod-shaped conductor (4) is encompassed, over a distance in the direction towards its central section (k), with a spacing, by a piece of tube (12, 13) of electrically conductive material, wherein the two tubular pieces (12, 13) are arranged concentrically to the insulating tube (5) and in each case the interspaces, which are in the shape of a circular ring cylinder and are formed by the insulating tube (5) and the respective tubular piece (12, 13), are connected to a second source (14 or 15) to produce an electromagnetic alternating field.

2.  Device for the production of plasma in a vacuum chamber (3) with the aid of electromagnetic alternating fields, wherein a rod-shaped conductor (4), within a tube (5) made of insulating material, is led through the vacuum chamber (3), and the internal diameter of the insulating tube (5) is larger than the diameter of the conductor (4), wherein the insulating tube (5) is held at both ends in walls (6, 7) of the vacuum chamber (3) and is sealed off relative to the walls (6, 7) on its outer surface, and the conductor (4) is connected at both ends respectively to a first source (8 or 9) to produce the electromagnetic alternating fields,
**characterised in that**
the rod-shaped conductor (4) is encompassed, with a spacing, by a tube (20) of electrically conductive material, and both ends of the tube (20) are respectively connected to a second source (14 or 15) to produce an electromagnetic alternating field, wherein the middle section of the tube (20) is equipped with a recess (21), for example an elongated, rhombus-shaped longitudinal slit.

**Revendications**

1. Dispositif pour la production de plasma dans une chambre à vide (3) au moyen de champs électromagnétiques alternatifs, dans lequel un conducteur (4) en forme de barre est guidé à travers la chambre à vide (3) à l'inférieur d'un tube (5) composé d'un matériau isolant, et dans lequel le diamètre intérieur du tube isolant (5) est plus grand que le diamètre du conducteur (4), le tube isolant (5) étant maintenu par ses deux extrémités dans des parois (6, 7) de la chambre à vide (3) et étanché sur sa face extérieure vis-à-vis des parois (6, 7), et le conducteur (4) étant connecté, à chacune de ses deux extrémités, à une première source (respectivement 8 ou 9) de production des champs électromagnétiques alternatifs, **caractérisé en ce que** le conducteur (4) en forme de barre est, au niveau de chacune des deux traversées (10, 11) des parois, entouré, avec un certain espacement et sur une certaine longueur en direction de sa partie centrale (k), par un morceau de tube (12, 13) qui est composé d'un matériau électroconducteur, les deux morceaux de tube (12, 13) étant disposés de façon concentrique par rapport au tube isolant (5) et chacun des espaces intermédiaires en forme de cylindre annulaire constitués par le tube isolant (5) et le morceau de tube (12, 13) correspondant étant raccordé à une deuxième source (14 ou 15 respectivement) de production d'un champ électromagnétique alternatif.

2. Dispositif pour la production de plasma dans une chambre à vide (3) au moyen de champs électromagnétiques alternatifs, dans lequel un conducteur (4) en forme de barre est guidé à travers la chambre à vide (3) à l'intérieur d'un tube (5) composé d'un matériau isolant, et dans lequel le diamètre intérieur du. tube isolant (5) est plus grand que le diamètre du conducteur (4), le tube isolant (5) étant maintenu par ses deux extrémités dans des parois (6, 7) de la chambre à vide (3) et étanché sur sa face extérieure vis-à-vis des parois (6, 7), et le conducteur (4) étant connecté, à chacune de ses deux extrémités, à une première source (respectivement 8 ou 9) de production des champs électromagnétiques alternatifs, **caractérisé en ce que** le conducteur (4) en forme de barre est entouré, avec un certain espacement, par un tube (20) composé d'un matériau électroconducteur, et que chacune des deux extrémités du tube (20) est connectée à une deuxième source (14 ou 15 respectivement) de production d'un champ électromagnétique alternatif, la partie centrale du tube (20) comportant une cavité (21), par exemple une fente longitudinale oblongue en forme de losange.

FIG.1

# FIG.2

# FIG.3

# FIG.4

# FIG.5

# FIG.6

Feldstärke des elektromagnetischen Wechselfeldes

A      B      Mitte Position      C      D

# FIG.7

Feldstärke des elektromagnetischen Wechselfeldes

E      F      Mitte Position      G      H